# EUROPEAN PATENT APPLICATION

(11) **EP 2 362 719 A1**
(43) Date of publication of application: **31.08.2011**
(21) Application number: 10159936.3
(22) Date of filing: 14.04.2010
(51) Int. Cl.: H05K 1/14, H01L 23/34, H01L 23/00

(54) **High-density integrated circuit module structure**

(30) Priority: 26.02.2010 TW 099105589
(71) Applicant: Walton Advanced Engineering Inc., Kaohsiung City 806 (TW)
(72) Inventor: Yu, Hong-Chi, Kaohsiung city, Taiwan 806 Chinese Taipei (TW)
(74) Representative: Joly, Jean-Jacques

(57) **Abstract**

A high-density integrated circuit module structure comprises at least a substrate (20) and a heat sink (30) wherein the substrates form a reversely-staggered contacting stack structure being formed with substrates electrically contacting heat sinks, and heat conductors (31) on the heat sink having at least one non-flat structure (311), allowing product's functions to be extended within an electronic product's restricted height, a better vibration resistance capability and heat dissipation effect, and simplified assembling procedure with no steps involving junctions between solder balls and a carrier, resulting in improved functions, increased capacity, and reduced manufacturing costs.

## Description

### BACKGROUND OF THE INVENTION

### 1. Field of the Invention

The present invention relates to an integrated circuit module structure, especially a high-density integrated circuit module structure.

### 2. Prior art description

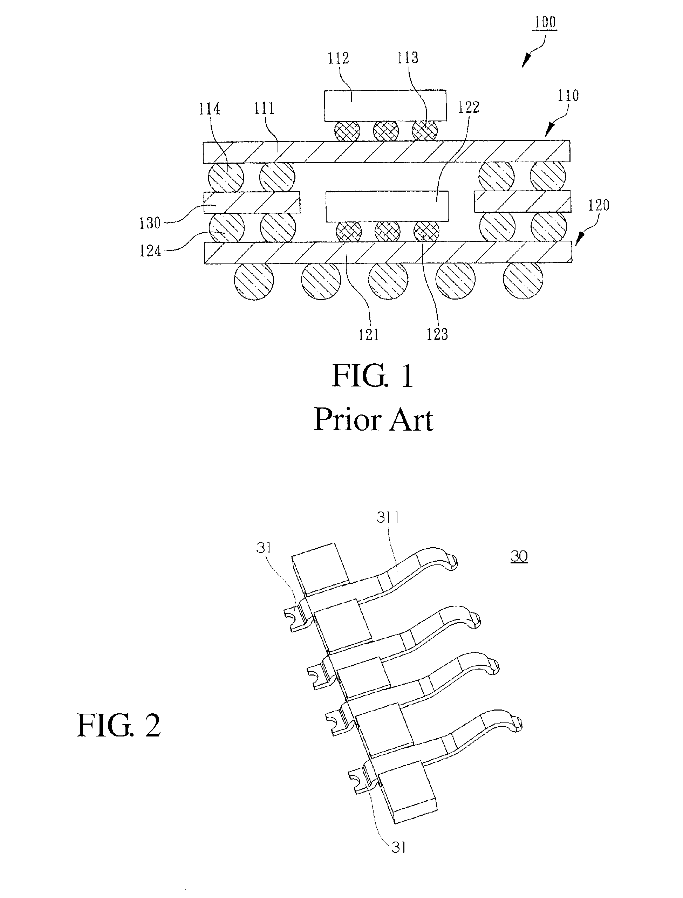

As shown in FIG. 1, a previous integrated circuit module structure (100) comprises a first package (110), a second package (120), and a carrier (130). The first package (110) comprises a first substrate (111), a first chip (112), a plurality of first bumps (113), and a plurality of first solder balls (114). The second package (120) comprises a second substrate (121), a second chip (122), a plurality of second bumps (123), and a plurality of second solder balls (124). The first chip (112) is bonded to the first substrate (111) with the flip-chip first bumps (113); the second chip (122) is bonded to the second substrate (121) with the flip-chip second bumps (123). To improve the product's functions, the first package (110) has to be stacked on and electrically connected to the second package (120) through the carrier (130), the first solder balls (114), and the second solder balls (124). However, in the integrated circuit module structure (100), the first package (110) for the purpose of electrically connecting the second package (120) has to reserve space for accommodating the carrier (130), the first solder balls (114), and the second solder balls (124) which are unfavorable to a shrunk thickness of the integrated circuit module structure (100) and inapplicable to a light, thin, short, and small electronic micro memory product. Additionally, the method to electrically connect the first package (110) and the second package (120) through the carrier (130), the first solder balls (114), and the second solder balls (124) results in a process with steps involving junctions of the first solder balls (114) and the second solder balls (124) without reduced assembling procedures or manufacturing costs consequentially. On the other hand, stress applied to the integrated circuit module structure (100) easily destroys the first solder balls (114) and the second solder balls (124) due to possible vibration and then leads to poor-quality connected signals. Furthermore, a high temperature developing from a first chip (112) and a second chip (122) under operation also gives rise to a problem of bad heat dissipation.

### SUMMARY OF THE INVENTION

To solve said problems, the present invention is intended to offer a high-density integrated circuit module structure comprising at least a substrate and a heat sink, a reversely-staggered contacting stack structure being formed with substrates which electrically contact the heat sinks to expand the product's functions within an electronic product's restricted height.

Another purpose of the present invention is to supply a high-density integrated circuit module structure comprising at least a substrate and a heat sink, a reversely-staggered contacting stack structure being formed with substrates which electrically contact the heat sink and the heat sink having heat conductors with at least one non-flat structure, providing capabilities of stress absorption, buffer, and better vibration resistance to maintain good-quality signal connection when the structure of present invention is subject to stress.

A further purpose of the present invention is to provide a high-density integrated circuit module structure comprising at least a substrate and a heat sink electrically contacting each other, to construct substrates with a reversely-staggered contacting stack structure, heat conductors of the heat sink providing the structure of invention with a better heat dissipation effect.

Another purpose of the present invention is to supply a high-density integrated circuit module structure which comprises at least a substrate and a heat sink electrically contacting each other, to construct substrates with a reversely-staggered contacting stack structure, by means of a simplified assembling procedure which does not require steps for forming junctions between solder balls and a carrier, resulting in improved functions, increased capacity, and reduced manufacturing costs due to no soldering points on bonding planes of the substrates.

To realize said purposes, the primary technical solutions provided by the present invention are as follows.

A high-density integrated circuit module structure according to the present invention comprises at least a substrate and a heat sink, the substrate having an inner surface and an outer surface which possesses a plurality of outer pads and a plurality of adapter pads, the outer pads being electrically connected to the adapter pads, and the substrate's inner surface being equipped with at least one electronic device electrically connected to the outer pads and the adapter pads; at least one heat sink having a plurality of heat conductors, the heat sink being installed on end planes of adapter pads on the substrate and the heat conductors contacting the adapter pads and having at least one non-flat structure; the outer pads of the substrate electrically contacting adapter pads on another substrate via the heat conductors to form an integrated circuit module with a reversely-staggered contacting high-density stack structure.

The purposes and solutions to technical problems of the present invention can be further achieved by the following technical features.

A high-density integrated circuit module structure mentioned previously has a substrate with outer pads electrically contacting adapter pads on another substrate via the heat conductors' non-flat structure.

A high-density integrated circuit module structure mentioned previously has a non-flat structure which comprises at least one of or a combination of the following shapes: a single bulge, a plurality of square-toothed profiles, a plurality of arch profiles, a plurality of round-toothed profiles, and a plurality of salient points.

A high-density integrated circuit module structure mentioned previously has the outer pads comprising metal contact points which are compatible with at least one of the following data communication interfaces: Universal Serial Bus (USB), Mini Universal Serial Bus (Mini USB), Micro Universal Serial Bus (Micro USB), or Serial Advanced Technology Attachment (e-SATA).

According to a further aspect of the present invention, a high-density integrated circuit module structure comprises at least a substrate, a heat sink, and an extended substrate, the substrate having an inner surface with a first port as well as at least one electronic device and an outer surface with a plurality of outer pads and a plurality of adapter pads electrically connecting each other for electrical connection between the first port and the electronic device; at least one heat sink comprising a plurality of heat conductors is installed on end planes of adapter pads on the substrate and the heat conductors contacting the adapter pads have a non-flat structure at least; at least one extended substrate has an inner surface comprising a second port and at least one electronic device which electrically connects the extended substrate; the outer pads of a substrate electrically contact the adapter pads of another substrate by the heat conductors and the second port of the extended substrate mutually couples with the first port of the substrate for transmitting signals of the electrically-connected integrated circuit module.

A high-density integrated circuit module structure mentioned previously has the electronic device on the extended substrate comprising a control chip and a memory wherein the control chip receives signals transmitted by the substrate through the second port which mutually couples with the first port of the substrate.

A high-density integrated circuit module structure mentioned previously has the electronic device on the substrate comprising a control chip and a memory wherein the control chip receives signals transmitted by the extended substrate through the first port which mutually couples with the second port of the extended substrate.

A high-density integrated circuit module structure mentioned previously has a substrate with the outer pads electrically contacting another substrate's adapter pads by the heat conductors' non-flat structure. A high-density integrated circuit module structure mentioned previously has the non-flat structure which comprises at least one of or a combination of the following shapes: a single bulge, a plurality of square-toothed profiles, a plurality of arch profiles, a plurality of round-toothed profiles, and a plurality of salient points.

A high-density integrated circuit module structure mentioned previously has the outer pads comprising metal contacts which are compatible with at least one of the following data communication interfaces: Universal Serial Bus (USB), Mini Universal Serial Bus (Mini USB), Micro Universal Serial Bus (Micro USB), or Serial Advanced Technology Attachment (e-SATA).

Having substrates electrically contacting heat sinks, substrates with a reversely-staggered contacting stack structure, and a non-flat structure of heat conductors on the heat sinks enables: (1) Extended product's functions within an electronic product's restricted height; (2) Capabilities such as stress absorption, buffer, and better vibration resistance to maintain good-quality signal connection supplied by the non-flat structure when the integrated circuit module structure is under stress; (3) Better heat dissipation effect of the substrates due to heat conductors on heat sinks; (4) A simplified assembling procedure with improved functions, increased capacity, and reduced manufacturing costs due to no soldering points on bonding planes of the substrates and no steps correlated with junctions between solder balls and a carrier in an assembling procedure consequentially.

### BRIEF DESCRIPTION OF THE DRAWINGS

FIG. 1 is a cross-sectional view of a high-density integrated circuit module structure according to the prior art.
FIG. 2 is a three-dimensional view of a heat sink according to an embodiment of the present invention.
FIG. 3 is a cross-sectional view of a high-density integrated circuit module structure according to an embodiment of the present invention.
FIG. 4-1 is a cross-sectional view of a heat sink's heat conductor which contacts an outer pad according to an embodiment of the present invention.
FIG. 4-2 is a cross-sectional view of a heat sink's heat conductor which contacts an adapter pad according to an embodiment of the present invention.
FIG. 5 is a cross-sectional view of a single bulge on a non-flat structure according to an embodiment of the present invention.
FIG. 6 is a cross-sectional view of a plurality of square-toothed profiles on a non-flat structure according to an embodiment of the present invention.
FIG. 7 is a cross-sectional view of a plurality of arch profiles on a non-flat structure according to an embodiment of the present invention.
FIG. 8 is a cross-sectional view of a plurality of round-toothed profiles on a non-flat structure according to an embodiment of the present invention.
FIG. 9-1 is a three-dimensional view of a plurality of salient points on a non-flat structure, according to an embodiment of the present invention.
FIG. 9-2 is a cross-sectional view along A-A in FIG. 9-1.
FIG. 10 is a cross-sectional view of a high-density integrated circuit module structure with a case included, according to an embodiment of the present invention.
FIG. 11 is a cross-sectional view of an embodiment of the present invention.

### DETAILED DESCRIPTION OF THE PREFERRED EMBODIMENT

To clearly interpret purposes, properties, and effects of the present invention, the preferred embodiments of the invention are listed as follows:

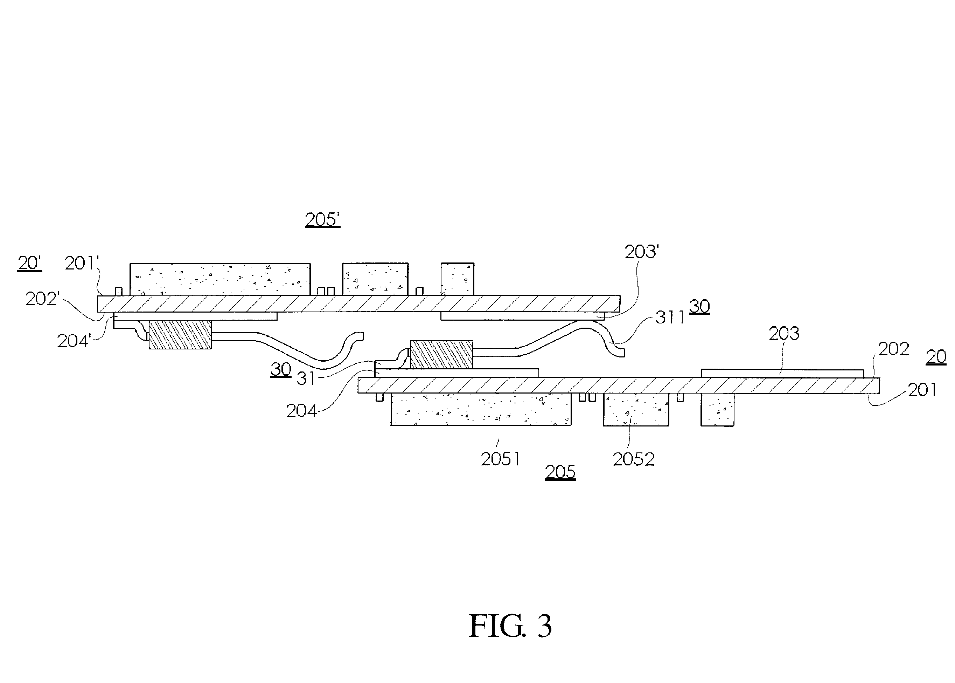

FIG. 2 and FIG. 3 show a high-density integrated circuit module structure mainly comprising at least one substrate (20) and one heat sink (30) according to a first embodiment of the invention. Taken as a chip carrier as well as a communication interface, the substrate (20) with an inner surface (201) and an outer surface (202) can be a high-density dual-conductive multi-layer printed circuit board with circuits developed inside (not shown in the drawings). In this regard, the outer surface (202) is provided with a plurality of outer pads (203) and a plurality of adapter pads (204), the outer pads (203) and the adapter pads (204) being reversely symmetrical and the outer pads (203) being electrically connected to the adapter pads (204) by circuits on the substrate (20) (not shown in the drawings). The outer pads (203) and the adapter pads (204) can be metal contact points, the metal contact points of the outer pads (203) being compatible with at least one of the following data communication interfaces: Universal Serial Bus (USB), Mini Universal Serial Bus (Mini USB), Micro Universal Serial Bus (Micro USB), and Serial Advanced Technology Attachment (e-SATA). In addition, the inner surfaces (201) of the substrates (20) are equipped with at least one electronic device (205) electrically connected to the outer pads (203) and the adapter pads (204) by bonding wires or a flip chip technique to electrically link the electronic device (205) and the substrates (20). Generally, the electronic device (205) comprises a control chip (2051) and a memory (2052) which can be a FLASH memory, a Static-Random-Access-Memory (SRAM), an Application-Specific-Integrated-Circuit (ASIC), a memory chip or a Synchronous-Dynamic-Random-Access-Memory (SDRAM). In this embodiment, the control chip (2051) is electrically connected to the memory (2052), the outer pads (203) and the adapter pads (204), controls storage and access into and from the memory (2052), and monitors the adapter pads (204) which are connected to another substrate (20') and transmit control signals to the other substrate (20').

The heat sink (30) comprises a plurality of heat conductors (31) and is installed on end planes of the adapter pads (204) on the substrate (20), the heat conductors (31) contacting the adapter pads (204) and having at least one non-flat structure (311). Thus, with the outer pads (203) on a substrate (20) electrically contacting adapter pads (204') on another substrate (20') via the heat conductors (31), an integrated circuit module is constructed with a reversely-staggered contacting high-density stack structure.

In a preferred embodiment, the outer pads (203) on a substrate (20) electrically contact adapter pads (204') on another substrate (20') via a non-flat structure of heat conductors (31), which allows the product's functions to be extended with more substrates horizontally linked within a product's restricted height and develops a better vibration resistance capability to maintain good-quality signal connection via the non-flat structure.

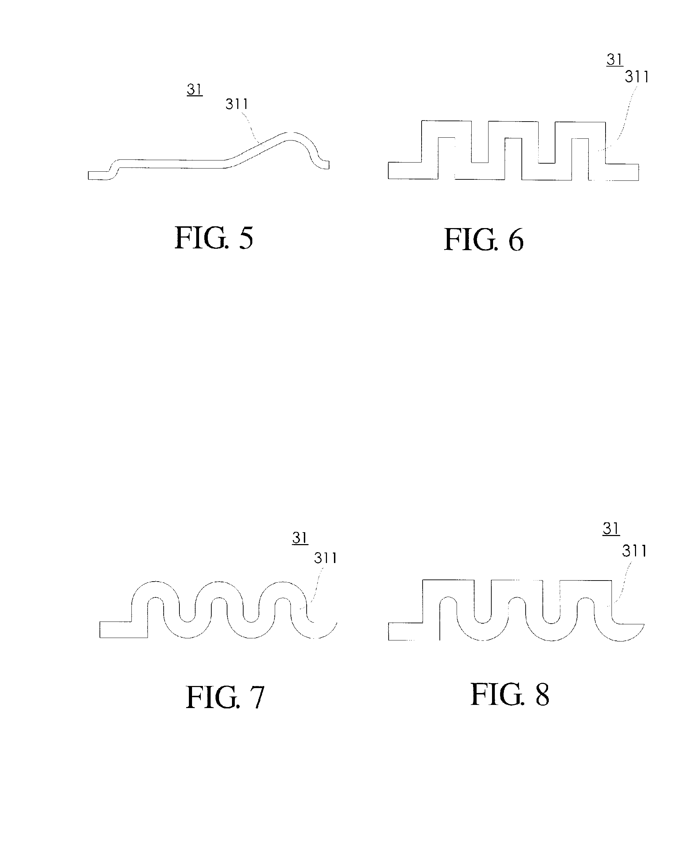

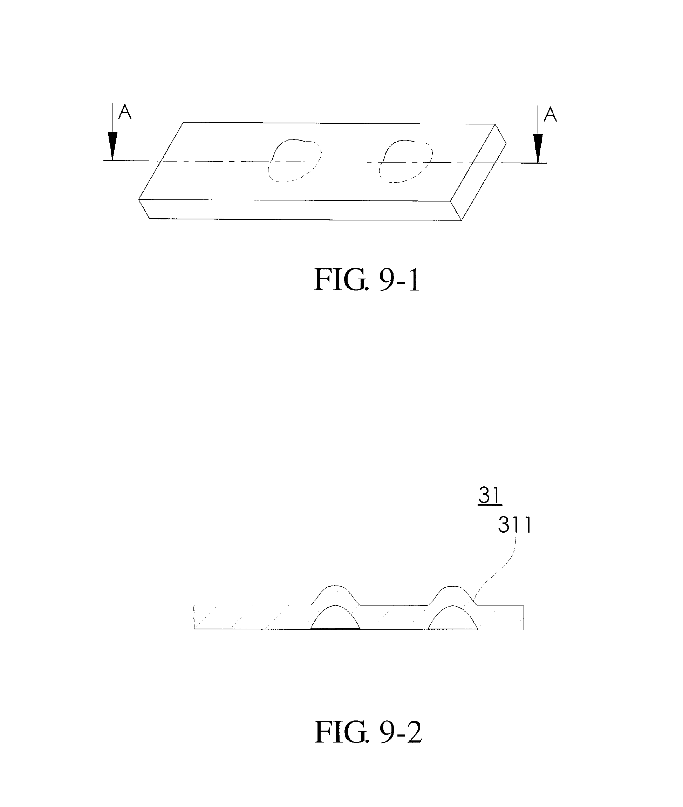

The shape of the non-flat structure (311) may comprise a single bulge (as shown in FIG. 5), a plurality of square-toothed profiles (as shown in FIG. 6), a plurality of arch profiles (as shown in FIG. 7), a plurality of round-toothed profiles (as shown in FIG. 8), a plurality of salient points (as shown in FIG. 9-1 and FIG. 9-2), a random combination of a single shape and a plurality of shapes mentioned previously, or a combination of another single shape and a plurality of shapes unlisted here.

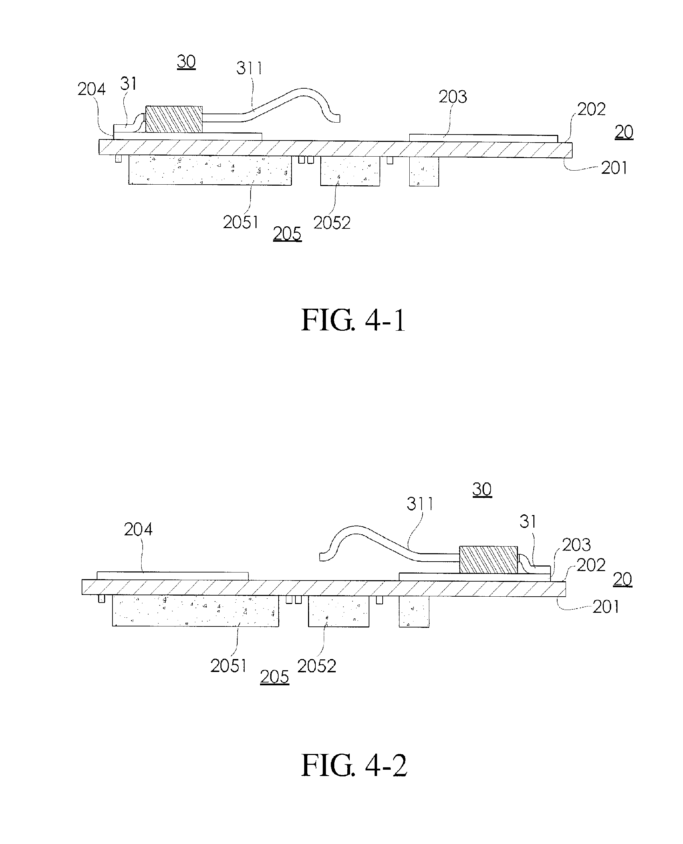

In addition, a method of bonding the heat sink (30) to one side of the substrate (20) in the vicinity of the outer pads (203) may be used which includes but is not limited to using a latch hook (not shown in the drawings), which realizes both the non-flat structure (311) contacting the outer pads (203) (as shown in FIG. 4-1) and the heat sink (30) bonding to one side of the substrate (20) in the vicinity of the adapter pads (204) to make the non-flat structure (311) contacting the adapter pads (204) (as shown in FIG. 4-2) for electrical conduction at plug-in. However, a bonding mechanism is not limited to a latch hook but any method extensively used in the industry such as riveting, mortise joint, fastener, lock, and imbedding may also be used.

Furthermore, because the steps in an assembling procedure of the prior art such as involving a carrier (130), first solder balls (114), and second solder balls (124) as shown in FIG. 1 are not required due to the absence of soldering points on bonding planes of the substrates (20, 20'), the assembling procedure is simplified resulting in improved functions and capacity and reduced manufacturing costs.

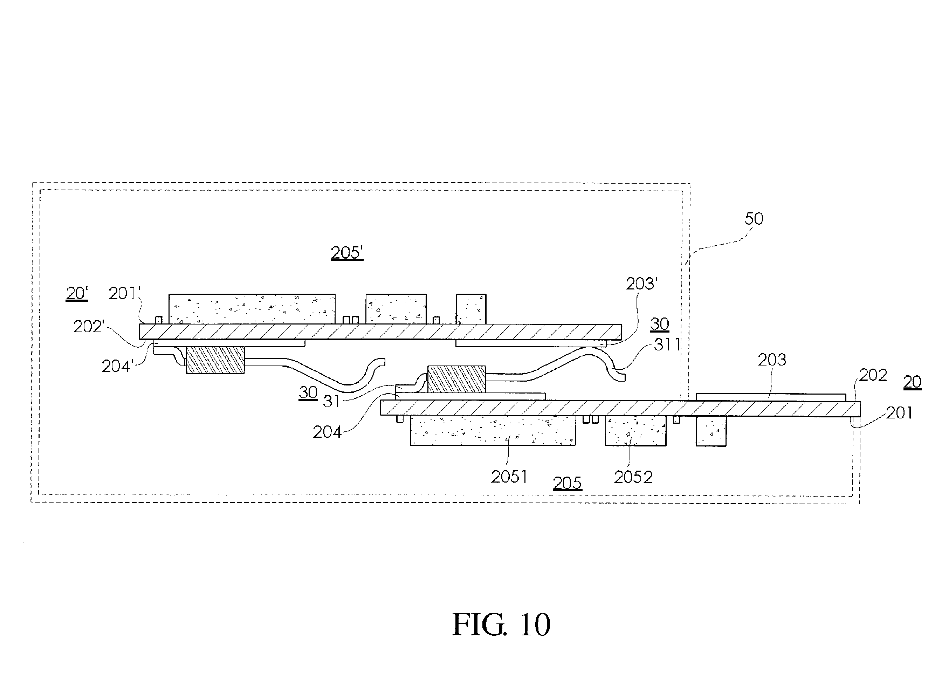

In a preferred embodiment, the heat conductors (31) on a heat sink (30) can be fabricated in copper, aluminum, or any other metals for thermal conduction of heat developed from the substrates (20, 20') and better heat dissipation. In addition, the heat sink (30) and the substrate (20) can be linked separately, that is a plug-in type. Furthermore, referring to FIG. 10, a case (50) may be added to accommodate a substrate (20) and a heat sink (30) inside but with outer pads (203) on the outer surface (202) of the substrate (20) being exposed outside the case (50) to link an external information device, such as a port of a computer's data communication interface, for data communication via metal contact points of the outer pads (203).

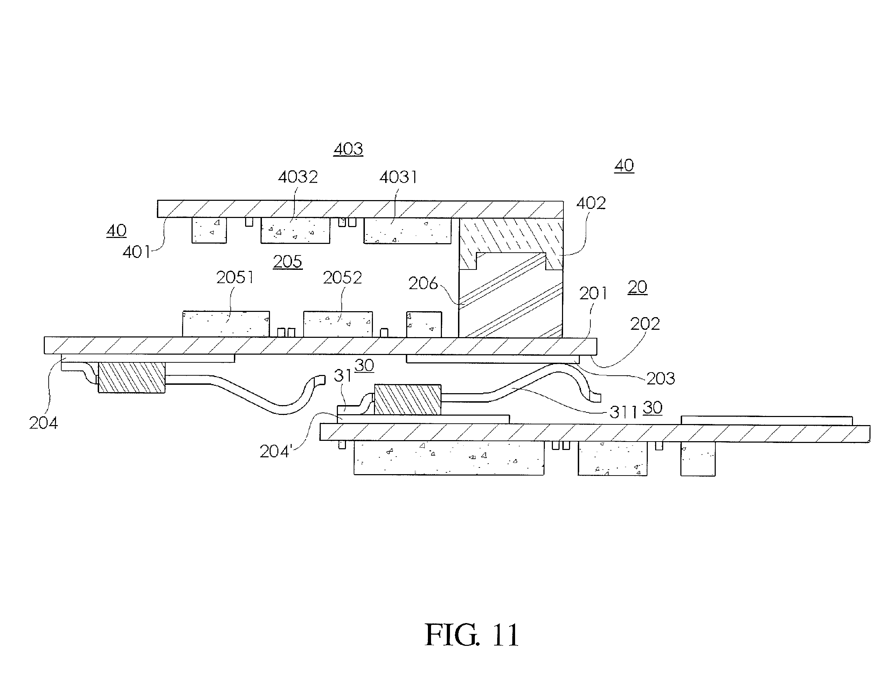

FIG. 11 shows a second embodiment of the present invention with a high-density integrated circuit module structure, having components which are similar to components of a high-density integrated circuit module structure illuminated of the first embodiment of FIG. 2 to FIG. 10, which have same reference numerals and which will not be again described.

The second embodiment differs in particular from the first embodiment in that, in the high-density integrated circuit module structure, the inner surfaces (201) of the substrates (20) are equipped with a first port (206), at least an electronic device (205) is electrically connected to outer pads (203) and adapter pads (204), and at least an extended substrate (40) is provided with an inner surface (401) comprising a second port (402) and at least an electronic device (403) electrically connected to the extended substrate (40). When outer pads (203) on the substrate (20) are in electrical contact with adapter pads (204') on another substrate (20') via the heat conductors (30), and the second port (402) on the extended substrate (40) mutually couples with the first port (206) on the substrate (20), the electrically connected integrated circuit module can be used to transmit signals.

In a preferred embodiment, the first port (206) and the second port (402) can be a male plug and a female socket of one connector respectively for the substrate (20) and the extended substrate (40) and securely bonded. An electronic device (403) on an extended substrate (40) comprises a control chip (4031) and a memory (4032), the control chip (4031) receiving signals from the substrate (20) via the second port (402) and the first port (206) on the substrate (20) which are mutually coupled; on the other hand, an electronic device (205) on the substrate (20) can comprise a control chip (2051) and a memory (2052), receiving signals from the extended substrate (40) via the first port (206) and the second port (402) on the extended substrate (40) which are mutually coupled. Thus, due to signal transmission between control chips (2051, 4031) on the substrate (20) and the extended substrate (40), the present invention expands a capacity to store existing data or creates other additional functions.

In summary, because the electrically contacted substrates and the heat sink in the present invention allow a construction of substrates in a reversely-staggered contacting stack structure, because at least an extended substrate can be added which electrically contacts a substrate, and because the heat sink's heat conductors have at least a non-flat structure, it is possible to obtain: (1) Extended product's functions within an electronic product's restricted height; (2) Capabilities such as stress absorption, buffer, and better vibration resistance to maintain good-quality signals connection due to the non-flat structure when the integrated circuit module structure is under stress; (3) Better heat dissipation effect of the substrates due to heat conductors on heat sinks; (4) A simplified assembling procedure with improved functions, increased capacity, and reduced manufacturing costs due to the absence of soldering points on bonding planes of the substrates and the absence of steps correlated with junctions between solder balls and a carrier in an assembling procedure consequentially.

## Claims

1. A high-density integrated circuit module structure, comprising:
at least one substrate (20) having an inner surface (201) and an outer surface (202) with a plurality of outer pads (203) and a plurality of adapter pads (204), the outer pads (203) being electrically connected to the adapter pads (204) and the inner surface (201) of the substrate (20) being equipped with at least one electronic device (205) electrically connected at least to the outer pads (203) and the adapter pads (204);
at least one heat sink (30) having a plurality of heat conductors (31), the heat sink (30) being installed on end planes of the adapter pads (204) on the substrate (20) and the heat conductors (31) contacting the adapter pads (204) and having at least one non-flat structure (311) at least;
the outer pads (203) of the substrate (20) electrically contacting adapter pads (204') on another substrate (20') via the heat conductors (31) to form an integrated circuit module with a reversely-staggered contacting high-density stack structure.

2. A high-density integrated circuit module structure according to Claim 1, wherein the outer pads (203) on a substrate (20) electrically contact the adapter pads (204') on another substrate (20') via a non-flat structure (311) of the heat conductors (31).

3. A high-density integrated circuit module structure according to Claim 1 or Claim 2, wherein the non-flat structure (311) comprises at least one of or a combination of the following shapes: a single bulge, a plurality of square-toothed profiles, a plurality of arch profiles, a plurality of round-toothed profiles, and a plurality of salient points.

4. A high-density integrated circuit module structure according to any one of Claims 1 to 3, wherein the outer pads (203) are metal contact points compatible with at least one of the following data communication interfaces:
Universal Serial Bus (USB), Mini Universal Serial Bus (Mini USB), Micro Universal Serial Bus (Micro USB), and Serial Advanced Technology Attachment (e-SATA).

5. A high-density integrated circuit module structure, comprising:
at least a substrate (20) having an inner surface (201) and an outer surface (202) with a plurality of outer pads (203) and a plurality of adapter pads (204), the outer pads (203) being electrically connected to the adapter pads (204 and the inner surface (201) of the substrate (20) being equipped with a first port (206) as well as with at least one electronic device (205) which is electrically connected to the outer pads (203) and the adapter pads (204);
at least a heat sink (30) with a plurality of heat conductors (31), the heat sink (30) being installed on end planes of the adapter pads (204) on the substrate (20), and the heat conductors (31) contacting the adapter pads (204) and having at least one non-flat structure (311); and
at least one extended substrate (40) having an inner surface (401), and comprising a second port (402) and at least one electronic device (403) which electrically connects to the extended substrate (40);
the outer pads (203) of a substrate (20) electrically contacting adapter pads (204') on another substrate (20') via the heat conductors (30) and the second port (402) of the extended substrate (40) mutually coupling with the first port (206) of the substrate (20) for signal communication of an electrically connected integrated circuit module.

6. A high-density integrated circuit module structure according to Claim 5, wherein the electronic device (403) on the extended substrate (40) comprises a control chip (4031) as well as a memory (4032) and the control chip (4031) receives signals from the substrate (20) via the second port (402) and the first port (206) on the substrate (20) which are mutually coupled.

7. A high-density integrated circuit module structure according to Claim 5 or Claim 6, wherein the electronic device (205) on the substrate (20) comprises a control chip (2051) as well as a memory (2052) and the control chip (2051) receives signals from the extended substrate (40) via the first port (206) and the second port (402) on the extended substrate (40) which are mutually coupled.

8. A high-density integrated circuit module structure according to any one of Claims 5 to 7, wherein outer pads (203) of the substrate (20) electrically contact adapter pads (204') of another substrate (20') via a non-flat structure (311) of the heat conductors (31).

9. A high-density integrated circuit module structure according to any one of Claims 5 to 8, wherein the non-flat structure (311) comprises at least one of or a combination of the following shapes: a single bulge, a plurality of square-toothed profiles, a plurality of arch profiles, a plurality of round-toothed profiles, and a plurality of salient points.

10. A high-density integrated circuit module structure according to any one of Claims 5 to 9, wherein the outer pads (203) are metal contact points compatible with at least one of the following data communication interfaces:
Universal Serial Bus (USB), Mini Universal Serial Bus (Mini USB), Micro Universal Serial Bus (Micro USB), and Serial Advanced Technology Attachment (e-SATA).
